(19) Europäisches Patentamt
European Patent Office
Office européen des brevets

(11)  EP 2 508 904 B1

## (12) EUROPEAN PATENT SPECIFICATION

(45) Date of publication and mention
of the grant of the patent:
**20.03.2019 Bulletin 2019/12**

(51) Int Cl.:
*G01R 31/36* (2019.01)     *G01R 31/02* (2006.01)
*G01R 31/08* (2006.01)     *H02H 3/14* (2006.01)
*H02H 3/16* (2006.01)      *H01M 10/48* (2006.01)

(21) Application number: **09851855.8**

(22) Date of filing: **03.12.2009**

(86) International application number:
**PCT/JP2009/070341**

(87) International publication number:
**WO 2011/067847 (09.06.2011 Gazette 2011/23)**

## (54) SECONDARY BATTERY SYSTEM

AKKUMULATORSYSTEM

SYSTÈME DE BATTERIE SECONDAIRE

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(43) Date of publication of application:
**10.10.2012 Bulletin 2012/41**

(73) Proprietor: **Toshiba Mitsubishi-Electric Industrial
Systems
Corporation
Minato-ku, Tokyo 108-0073 (JP)**

(72) Inventor: **ITAMI, Takao
Minato-ku
Tokyo 108-0073 (JP)**

(74) Representative: **Zech, Stefan Markus et al
Meissner Bolte Patentanwälte
Rechtsanwälte Partnerschaft mbB
Widenmayerstraße 47
80538 München (DE)**

(56) References cited:
EP-A1- 1 275 969        EP-A1- 1 289 094
EP-A1- 1 437 600        EP-A1- 1 898 227
EP-A1- 2 105 753        CN-Y- 201 210 625
DE-A1- 10 304 234       JP-A- 57 161 665
JP-A- 58 018 173        JP-A- H03 179 272
JP-A- H06 153 303       JP-A- H06 308 185
JP-A- H07 203 601       JP-A- H07 218 569
JP-A- H08 163 704       US-A- 5 760 587
US-A1- 2003 137 319     US-A1- 2006 003 198
US-A1- 2007 285 057

**Description**

Technical Field

The present invention relates to a secondary battery system for detecting a ground fault position in an assembly battery that uses secondary cells.

Background Art

There has heretofore been known an assembly battery system that uses an assembly battery composed of electric cells comprising sodium-sulfur cells (hereinafter referred to as "NAS cells"). For example, such an assembly battery system is used to store electric power in the night. In the assembly battery system, in the event of a ground fault accident in one of the electric cells, a ground fault detecting device detects the ground fault accident. When the ground fault accident is detected, the assembly battery system is stopped for recovery.

In the meantime, various ground fault detecting devices for cells are known. For example, according to one disclosure, cells are grounded via resistances so that the cathodes and anodes alternate, and the voltages of the grounded cells are measured to obtain ground fault resistance and thereby detect a ground fault (e.g. Jpn. Pat. Appln. KOKAI Publication No. 5-273287 (hereinafter referred to as a "Literature 1")). According to another disclosure, in an assembly battery in which a number of cell groups of series-connected secondary cells are connected in parallel, circuits are sequentially opened line by line to determine whether the cell groups of closed circuits have caused a ground fault (e.g. Jpn. Pat. Appln. KOKAI Publication No. 7-325121 (hereinafter referred to as a "Literature 2")).

However, if the ground fault detecting device according to Literature 1 is applied to the above-described assembly battery system, it takes much time to identify a ground fault spot, and the recovery of the assembly battery system is delayed.

On the other hand, the ground fault detecting device according to Literature 2 requires a breaker provided for each of the cell groups to identify a ground fault spot. Therefore, if the breakers cannot be provided due to restrictions such as the design of the assembly battery, this ground fault detecting device cannot be used.

Relevant prior art documents are also JP-H08-163704 A, EP 1 275 969 A1, EP 2 105 753 A1, JP-H07-218569 A, JP-H07-203601 A, JP-H06-153303 A and US 5,760,587 A.

Disclosure of Invention

It is an object the present invention to provide a secondary battery system capable of rapidly specifying a ground fault position in an assembly battery that uses secondary cells.

According to the present invention, there is provided a ground fault detecting device as specified in claim 1 and a secondary battery system according to claim 4. Advantageous embodiments are specified in the dependent claims.

Brief Description of Drawings

FIG. 1 is a diagram showing the configuration of a secondary battery system 1 according to an embodiment of the present invention; and
FIG. 2 is a circuit diagram illustrating how a ground fault spot is detected by a ground fault detecting device 3 according to the embodiment.

Best Mode for Carrying Out the Invention

An embodiment of the present invention will be described hereinafter with reference to the drawings.

(Embodiment)

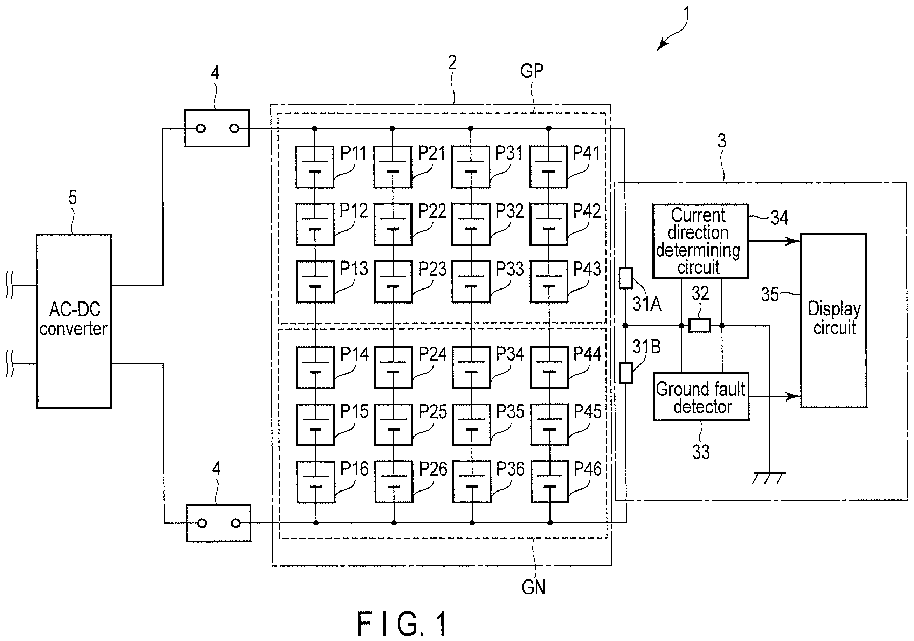

FIG. 1 is a diagram showing the configuration of a secondary battery system 1 according to an embodiment of the present invention. It is to be noted that like components in the following drawing are provided with like reference signs and are not described in detail and that differences are mainly described. Repeated explanations are also omitted in the following embodiment.

The secondary battery system 1 comprises an assembly battery 2, a ground fault detecting device 3, an AC-DC converter 5 connected to the assembly battery 2, and two breakers 4 connected between the assembly battery 2 and the AC-DC converter 5.

The assembly battery 2 supplies direct-current power to the AC-DC converter 5 in the daytime, and is charged with direct-current power from the AC-DC converter 5 in the night.

The assembly battery 2 comprises four cell groups P11 to P16, P21 to P26, P31 to P36, and P41 to P46 that are connected in parallel.

The cell group P11 to P16 comprises six electric cells P11, P12, P13, P14, P15, and P16 that are connected in series. The cell group P21 to P26 comprises six electric cells P21, P22, P23, P24, P25, and P26 that are connected in series. The cell group P31 to P36 comprises six electric cells P31, P32, P33, P34, P35, and P36 that are connected in series. The cell group P41 to P46 comprises six electric cells P41, P42, P43, P44, P45, and P46 that are connected in series.

The electric cells P11 to P46 are high-temperature-activated NAS cells that are activated at about 300°C.

The ground fault detecting device 3 comprises two voltage dividing resistances 31A and 31B, a ground fault detecting resistance 32, a ground fault detector 33, a current direction determining circuit 34, and a display circuit 35.

The two voltage dividing resistances 31A and 31B are connected in series between the cathode and anode of the assembly battery 2. The two voltage dividing resistances 31A and 31B have the same resistance value. Therefore, the voltage of the assembly battery 2 is equally divided from a middle point which is a connection point of the two voltage dividing resistances 31A and 31B. That is, the potential of the intermediate point is an intermediate potential between the potentials of the cathode and anode of the assembly battery 2.

The ground fault detecting resistance 32 has one terminal connected to the intermediate point of the two voltage dividing resistances 31A and 31B and has the other terminal end grounded.

The ground fault detector 33 measures a current running through the ground fault detecting resistance 32. When the amount of the current running through the ground fault detecting resistance 32 is equal to or more than a predetermined value, the ground fault detector 33 detects that a ground fault has occurred.

The current direction determining circuit 34 determines the direction of the current running through the ground fault detecting resistance 32. The current direction determining circuit 34 specifies a ground fault spot in the assembly battery 2 in accordance with the determined current direction.

The display circuit 35 displays an occurrence of a ground fault when the ground fault detector 33 detects the ground fault. At the same time, the display circuit 35 displays the ground fault spot specified by the current direction determining circuit 34.

In the daytime, the AC-DC converter 5 converts direct-current power supplied from the assembly battery 2 to alternating-current power, and then supplies the alternating-current power to a load. In the night, the AC-DC converter 5 converts alternating-current power received from a power-supply-side electric system to direct-current power, and charges the assembly battery 2 with the direct-current power.

The breakers 4 connect/disconnect the AC-DC converter 5 and the assembly battery 2. The two breakers 4 are provided on the cathode side and the anode side, respectively. The breakers 4 are turned on when the secondary battery system 1 is in use. For example, in the event of a trouble such as a ground fault in the assembly battery 2, the breakers 4 are turned off to disconnect the assembly battery 2 from the secondary battery system 1.

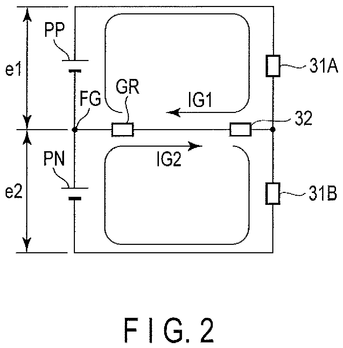

Now, how a ground fault spot is specified by the ground fault detecting device 3 is described with reference to FIG. 2.

FIG. 2 is a circuit diagram illustrating how a ground fault spot is specified by the ground fault detecting device 3 according to the embodiment.

A point FG represents a ground fault spot. A power supply PP represents all the electric cells located on the cathode side from the ground fault spot. A power supply PN represents all the electric cells located on the anode side from the ground fault spot. A ground fault resistance GR represents the electric resistance of the ground fault spot.

For example, when a ground fault spot is located between the electric cell P11 and the electric cell P12 shown in FIG. 1, the power supply PP represents the electric cell P11, and the power supply PN represents the electric cells P12 to P16.

Here, the following equations are derived:

$$IG1 = e1/(R+R0+r) \ \dots \ \text{Equation (1)}$$

$$IG2 = e2/(R+R0+r) \ \dots \ \text{Equation (2)}$$

wherein e1 is the voltage of the power supply PP, e2 is the voltage of the power supply PN, R is the resistance value of the voltage dividing resistances 31A and 31B, r is the resistance value of the ground fault resistance GR, R0 is the ground fault detecting resistance 32, IG1 is the current running through the closed circuit on the side of the power supply PP, and IG2 is the current running through the closed circuit on the side of the power supply PN.

The following equation is derived from Equation (1) and Equation (2):

$$e1/IG1 = e2/IG2 \quad ... \quad Equation \ (3).$$

The following are known from Equation (3).

If the direction of the current in the ground fault detecting resistance 32 is IG1 (when the current runs toward the ground), then IG1>IG2, leading to e1>e2. This shows that the number of electric cells located on the cathode side from the ground fault spot is larger than the number of electric cells located on the anode side.

Thus, an electric cell which has caused a ground fault is specified to be one of the electric cells P14 to P16, P24 to P26, P34 to P36, and P44 to P46 in a range GN on the anode side.

On the other hand, if the direction of the current in the ground fault detecting resistance 32 is IG2 (when the current runs toward the assembly battery 2), then IG1<IG2, leading to e1<e2. This shows that the number of electric cells located on the cathode side from the ground fault spot is smaller than the number of electric cells located on the anode side.

Thus, an electric cell which has caused a ground fault is specified to be one of the electric cells P11 to P13, P21 to P23, P31 to P33, and P41 to P43 in a range GP on the cathode side.

According to the embodiment, in the assembly battery system 1, a ground fault spot can be rapidly specified by the ground fault detecting device 3.

Furthermore, as the ground fault detecting device 3 requires no breakers and changeover switches to detect a ground fault, the ground fault detecting device 3 can be used in various assembly battery systems and is highly versatile.

Moreover, as the ground fault detecting device 3 requires no special operations (operations such as the turning on/off of the breakers and the turning of the changeover switches) in detecting a ground fault, the ground fault detecting device 3 can immediately detect a ground fault.

Although the assembly battery 2 comprises 24 electric cells in the embodiment described, the present invention is not limited to thereto. Any number of electric cells may be connected in series in a cell group that constitutes the assembly battery 2. Moreover, any number of electric cells may be connected in parallel.

Although the NAS cell is used as the secondary cell in the embodiment, other cells may be used instead.

It is to be noted that the present invention is not completely limited to the embodiment described above, and modifications of components can be made at the stage of carrying out the invention without departing from the scope thereof, which is defined by the appended claims.

Industrial Applicability

According to the present invention, it is possible to provide a secondary battery system capable of rapidly specifying a ground fault position in an assembly battery that uses secondary cells.

**Claims**

1. A ground fault detecting device (3) configured to detect a ground fault in a secondary battery system (1) comprising an assembly battery in which two or more secondary cells (P11-P46) are connected in series, the ground fault detecting device (3) comprising:

   two voltage dividing resistances (31A, 31B) which are adapted to equally divide a line voltage across a cathode and an anode of the assembly battery (2) from the intermediate point;
   a ground fault detecting resistance (32) which grounds the intermediate point attributed to the two voltage dividing resistances (31A, 31B); and
   a ground fault detecting means (33) for detecting a ground fault in accordance with a current running through the ground fault detecting resistance (32);
   **characterised in that** the ground fault detecting device further comprises
   a ground fault spot determining means (34) for determining whether a ground fault spot (FG) is on a cathode side or an anode side of the assembly battery (2) in accordance with the direction of the current running through the ground fault detecting resistance (32).

2. The ground fault detecting device (3) of the secondary battery system according to claim 1, **characterized by** comprising:
   a ground fault displaying means (35) for displaying an occurrence of a ground fault when the ground fault is detected by the ground fault spot determining means (34).

**3.** The ground fault detecting device (3) of the secondary battery system according to claim 1, **characterized by** comprising:
a ground fault spot displaying means (35) for displaying the ground fault spot (FG) when the ground fault spot (FG) is determined by the ground fault spot determining means (34).

**4.** A secondary battery system (1) comprising:

an assembly battery (2) in which two or more secondary cells (P11-P46) are connected in series; and
the ground fault detecting device (3) of claim 1.

**5.** The secondary battery system (1) according to claim 4, **characterized by** comprising:
a ground fault displaying means (35) for displaying an occurrence of a ground fault when the ground fault is detected by the ground fault spot determining means (34).

**6.** The secondary battery system (1) according to claim 5, **characterized by** comprising:
ground fault spot displaying means (35) for displaying the ground fault spot (FG) when the ground fault spot (FG) is determined by the ground fault spot determining means (34).


**Patentansprüche**

**1.** Erdschluss-Detektionsvorrichtung (3), die dazu ausgebildet ist, einen Erdschluss bei einem Akkumulator-System (1) zu detektieren, das eine Batterieanordnung aufweist, bei der zwei oder mehrere Sekundärzellen (P11-P46) in Reihe geschaltet sind, wobei die Erdschluss-Detektionsvorrichtung (3) Folgendes aufweist:

zwei Spannungsteiler-Widerstände (31A, 31B), die dazu ausgelegt sind, eine Netzspannung gleichmäßig über eine Kathode und eine Anode der Batterieanordnung (2) von dem dazwischenliegenden Punkt aus zu teilen;
ein Erdschluss-Detektionswiderstand (32), der den dazwischenliegenden Punkt erdet, der den zwei Spannungsteiler-Widerständen (31A, 31B) zugeordnet ist; und
ein Erdschluss-Detektionsmittel (33) zum Detektieren eines Erdschlusses einem Strom entsprechend, der durch den Erdschluss-Detektionswiderstand (32) läuft;
**gekennzeichnet dadurch, dass** die Erdschluss-Detektionsvorrichtung ferner Folgendes aufweist:
ein Erdschluss-Punkt-Ermittlungsmittel (34) zum Ermitteln, ob sich ein Erdschluss-Punkt (FG) der Richtung des Stroms entsprechend, der durch den Erdschluss-Detektionswiderstand (32) läuft, auf einer Kathodenseite oder einer Anodenseite der Batterieanordnung (2) befindet.

**2.** Erdschluss-Detektionsvorrichtung (3) des Akkumulator-Systems gemäß Anspruch 1, **gekennzeichnet dadurch, dass** sie Folgendes aufweist:
ein Erdschluss-Anzeigemittel (35) zum Anzeigen des Auftretens eines Erdschlusses, wenn der Erdschluss von dem Erdschluss-Punkt-Ermittlungsmittel (34) detektiert wird.

**3.** Erdschluss-Detektionsvorrichtung (3) des Akkumulator-Systems gemäß Anspruch 1, **dadurch gekennzeichnet, dass** sie Folgendes aufweist:
ein Erdschluss-Punkt-Anzeigemittel (35) zum Anzeigen des Erdschluss-Punkts (FG), wenn der Erdschluss-Punkt (FG) von dem Erdschluss-Punkt-Ermittlungsmittel (34) ermittelt wird.

**4.** Akkumulator-System (1), das Folgendes aufweist:

eine Batterieanordnung (2), bei der zwei oder mehrere Sekundärzellen (P11-P46) in Reihe geschaltet sind; und
die Erdschluss-Detektionsvorrichtung (3) gemäß Anspruch 1.

**5.** Akkumulator-System (1) gemäß Anspruch 4, **gekennzeichnet dadurch, dass** es Folgendes aufweist:
ein Erdschluss-Anzeigemittel (35) zum Anzeigen des Auftretens eines Erdschlusses, wenn der Erdschluss von dem Erdschluss-Punkt-Ermittlungsmittel (34) detektiert wird.

**6.** Akkumulator-System (1) gemäß Anspruch 5, **gekennzeichnet dadurch, dass** es Folgendes aufweist:
ein Erdschluss-Punkt-Anzeigemittel (35) zum Anzeigen des Erdschluss-Punkts (FG), wenn der Erdschluss-Punkt (FG) von dem Erdschluss-Punkt-Ermittlungsmittel (34) ermittelt wird.

**Revendications**

1. Dispositif de détection de fuite à la terre (3) configuré pour détecter une fuite à la terre dans un système d'accumulateur secondaire (1) comprenant un accumulateur d'assemblage dans lequel deux ou plusieurs piles secondaires (P11-P46) sont connectées en série, le dispositif de détection de fuite à la terre (3) comprenant :

   deux résistances de division de tension (31A, 31B) qui sont adaptées pour diviser de manière égale une tension de ligne à travers une cathode et une anode de l'accumulateur d'assemblage (2) à partir du point intermédiaire ;
   une résistance de détection de fuite à la terre (32) qui met à la terre l'endroit intermédiaire attribué aux deux résistances de division de tension (31A, 31B) ; et
   un moyen de détection de fuite à la terre (33) pour détecter une fuite à la terre selon un courant passant à travers la résistance de détection de fuite à la terre (32) ;
   **caractérisé en ce que** le dispositif de détection de fuite à la terre comprend de plus
   un moyen de détermination d'endroit de fuite à la terre (34) pour déterminer si un point de fuite à la terre (FG) se trouve sur un côté de cathode ou un côté d'anode de l'accumulateur d'assemblage (2) selon la direction du courant passant à travers la résistance de détection de fuite à la terre (32).

2. Dispositif de détection de fuite à la terre (3) du système d'accumulateur secondaire selon la revendication 1, **caractérisé en ce qu'**il comprend :
   un moyen d'affichage d'endroit de fuite à la terre (35) pour afficher une apparition d'une fuite à la terre lorsque la fuite à la terre est détectée par le moyen de détermination d'endroit de fuite à la terre (34).

3. Dispositif de détection de fuite à la terre (3) du système d'accumulateur secondaire selon la revendication 1, **caractérisé en ce qu'**il comprend :
   un moyen d'affichage d'endroit de fuite à la terre (35) pour afficher l'endroit de fuite à la terre (FG) lorsque l'endroit de fuite à la terre (FG) est déterminé par le moyen de détermination d'endroit de fuite à la terre (34).

4. Système d'accumulateur secondaire (1) comprenant :

   un accumulateur d'assemblage (2) dans lequel deux ou plusieurs piles secondaires (P11-P46) sont connectées en série ; et
   le dispositif de détection de fuite à la terre (3) selon la revendication 1.

5. Système d'accumulateur secondaire (1) selon la revendication 4, **caractérisé en ce qu'**il comprend :
   un moyen d'affichage de fuite à la terre (35) pour afficher une apparition d'une fuite à la terre lorsque la fuite à la terre est détectée par le moyen de détermination d'endroit de fuite à la terre (34).

6. Système d'accumulateur secondaire (1) selon la revendication 5, **caractérisé en ce qu'**il comprend :
   un moyen d'affichage d'endroit de fuite à la terre (35) pour afficher l'endroit de fuite à la terre (FG) lorsque l'endroit de fuite à la terre (FG) est déterminé par le moyen de détermination d'endroit de fuite à la terre (34).

F I G. 1

EP 2 508 904 B1

F I G. 2

**REFERENCES CITED IN THE DESCRIPTION**

**Patent documents cited in the description**

- JP 5273287 A
- JP 7325121 A
- JP H08163704 A
- EP 1275969 A1
- EP 2105753 A1
- JP H07218569 A
- JP H07203601 A
- JP H06153303 A
- US 5760587 A